# EUROPEAN PATENT APPLICATION

(11) **EP 2 811 537 A2**
(43) Date of publication of application: **10.12.2014**
(21) Application number: 14162960.0
(22) Date of filing: 31.03.2014
(51) Int. Cl.: H01L 31/072, H01L 31/18

(54) **Photoelectric module and method of manufacturing the same**

(30) Priority: 05.06.2013 KR 20130064960
(71) Applicant: Samsung SDI Co., Ltd., Yongin-si, Gyeonggi-do (KR)
(72) Inventor: OH, Min-Seok, Gyeonggi-do (KR); PARK, Soon-Young, Gyeonggi-do (KR); LEE, Yun-Seok, Gyeonggi-do (KR); KIM, Young-Jin, Gyeonggi-do (KR)
(74) Representative: Mounteney, Simon James

(57) **Abstract**

A photoelectric module includes a substrate, a first photoelectric conversion unit that is formed on the substrate and has a first light-receiving surface, and a second photoelectric conversion unit that is formed under the substrate and has a second light-receiving surface, wherein a front electrode of the second photoelectric conversion unit has a thickness smaller than that of a front electrode of the first photoelectric conversion unit. Also, the photoelectric module is a dual-side light-receiving photoelectric module having light-receiving surfaces on and under the substrate, and the first and second photoelectric conversion units respectively formed on the upper and lower surfaces of the substrate are differently designed to compensate for an intensity difference of incident light. Methods of manufacturing the dual-side light-receiving photoelectric module are provided.

## Description

### BACKGROUND

### 1. Field

The present invention is directed towards a photoelectric module and a method of manufacturing a photoelectric module.

### 2. Description of the Related Art

Recently, due to the problems of depletion of energy resources and global environmental issues, the development of clean energy has become highly desirable. Photovoltaic power generation, in which solar energy is directly converted to electricity, is expected to become a significant source of clean energy.

However, currently, the cost for commercial photovoltaic power generation is still high when compared to a fossil-based power generation. Therefore, there is a need to increase the efficiency of photovoltaic power generation in order to facilitate its application in various industrial fields.

### SUMMARY

The present invention sets out to improve the efficiency of photovoltaic power generation.

One or more aspects according to embodiments of the present invention are directed toward photoelectric modules having light-receiving surfaces on and under a substrate. More particularly, one or more aspects according to embodiments of the present invention are directed toward dual-side light-receiving photoelectric modules in which photoelectric conversion units formed on and under a substrate are differently designed to compensate for an intensity difference of incident light, and a method of manufacturing the same.

Additional aspects will be set forth in part in the description which follows and, in part, will be apparent from the description, or may be learned by practice of the presented embodiments.

According to one or more embodiments of the present invention, a photoelectric module includes: a substrate; a first photoelectric conversion unit on the substrate and having a first light-receiving surface and a front electrode; and a second photoelectric conversion unit under the substrate and having a second light-receiving surface and a front electrode, wherein the front electrode of the second photoelectric conversion unit has a thickness smaller than that of the front electrode of the first photoelectric conversion unit.

The front electrode of the second photoelectric conversion unit may have a thickness of at least 0.6 µm.

The first photoelectric conversion unit may include a plurality of photoelectric cells of a first group and the second photoelectric conversion unit may include a plurality of photoelectric cells of a second group, and a width of the plurality of photoelectric cells of the second group is smaller than that of the plurality of photoelectric cells of the first group.

The first photoelectric conversion unit may include a rear electrode, an optical absorption layer, and the front electrode sequentially stacked from an upper surface of the substrate, and the second photoelectric conversion unit may include a rear electrode, an optical absorption layer, and the front electrode sequentially stacked from a lower surface of the substrate.

The front electrodes of the first and second photoelectric conversion units may include a transparent conductive material.

When the rear electrodes of the first and second photoelectric conversion units are separated into a plurality of rear electrodes of neighboring photoelectric cells by a plurality of first separation patterns, a distance between the first separation patterns of two neighboring photoelectric cells in the second photoelectric conversion unit may be smaller than that between the first separation patterns of two neighboring photoelectric cells in the first photoelectric conversion unit.

When the optical absorption layers of the first and second photoelectric conversion units are separated into a plurality of optical absorption layers of neighboring photoelectric cells by a plurality of second separation patterns, a distance between the second separation patterns of two neighboring photoelectric cells in the second photoelectric conversion unit may be smaller than that between the second separation patterns of two neighboring photoelectric cells in the first photoelectric conversion unit.

When the front electrodes of the first and second photoelectric conversion units are separated into a plurality of front electrodes of neighboring photoelectric cells by a plurality of third separation patterns, a distance between the third separation patterns of two neighboring photoelectric cells in the second photoelectric conversion unit may be smaller than that between the third separation patterns of two neighboring photoelectric cells in the first photoelectric conversion unit.

According to one or more embodiments of the present invention, a photoelectric module includes: a substrate; a first photoelectric conversion unit on the substrate and including a plurality of photoelectric cells of a first group; and a second photoelectric conversion unit under the substrate and including a plurality of photoelectric cells of a second group, wherein the plurality of photoelectric cells of the second photoelectric conversion unit have a width smaller than that of the plurality of photoelectric cells of the first photoelectric conversion unit.

The plurality of photoelectric cells of the second group each may have a width of at least 3 mm.

The first photoelectric conversion unit may include a rear electrode, an optical absorption layer, and a front electrode sequentially stacked from an upper surface of the substrate, and the second photoelectric conversion unit may include a rear electrode, an optical absorption layer, and a front electrode sequentially stacked from a lower surface of the substrate.

When the rear electrodes of the first and second photoelectric conversion units are separated into a plurality of rear electrodes of neighboring photoelectric cells by a plurality of first separation patterns, a distance between the first separation patterns of two neighboring photoelectric cells in the second photoelectric conversion unit may be smaller than that between the first separation patterns of two neighboring photoelectric cells in the first photoelectric conversion unit.

When the optical absorption layers of the first and second photoelectric conversion units are separated into a plurality of optical absorption layers of neighboring photoelectric cells by a plurality of second separation patterns, a distance between the second separation patterns of two neighboring photoelectric cells in the second photoelectric conversion unit may be smaller than that between the second separation patterns of two neighboring photoelectric cells in the first photoelectric conversion unit.

When the front electrodes of the first and second photoelectric conversion units are separated into a plurality of front electrodes of neighboring photoelectric cells by a plurality of third separation patterns, a distance between the third separation patterns in the second photoelectric conversion unit of two neighboring photoelectric cells may be smaller than that between the third separation patterns of two neighboring photoelectric cells in the first photoelectric conversion unit.

The front electrode of the second photoelectric conversion unit may have a thickness smaller than that of the front electrode of the first photoelectric conversion unit.

According to one or more embodiments of the present invention, a method of manufacturing a photoelectric module includes: preparing a substrate; forming layers of rear electrodes on and under the substrate; forming a plurality of first separation patterns to separate the layers of rear electrodes into a plurality of rear electrodes; forming optical absorption layers on the rear electrodes and respectively located on and under the substrate; forming buffer layers on the optical absorption layers and respectively located on and under the substrate; and forming front electrodes on the buffer layers and respectively located on and under the substrate, wherein the front electrode under the substrate has a thickness smaller than that of the front electrode on the substrate.

In the forming of the optical absorption layers, the optical absorption layers respectively located on and under the substrate may be concurrently formed.

The forming of the optical absorption layers may include: forming a precursor on the substrate; performing a flip step process for overturning upper and lower surfaces of the substrate; forming a precursor under the substrate; and performing selenization in which Se is supplied or sulfurization in which sulfur is supplied onto the precursors formed on and under the substrate, wherein in the performing of the selenization or sulfurization, Se or S is concurrently supplied to the precursors formed on and under the substrate.

In the forming of the buffer layers, the buffer layers formed on and under the substrate may be concurrently formed.

After forming the buffer layers, an annealing process for drying the resultant product is performed, the annealing process is concurrently performed with respect to the buffer layers on and under the substrate.

At least some of the above and other features of the invention are set out in the claims.

### BRIEF DESCRIPTION OF THE DRAWINGS

These and/or other aspects will become apparent and more readily appreciated from the following description of the embodiments, taken in conjunction with the accompanying drawings in which:
FIG. 1 is a cross-sectional view of a photoelectric module according to an embodiment of the present invention;
FIGS. 2A through 2D are schematic cross-sectional views of a model for simulating an intensity difference of incident light between first and second photoelectric conversion units respectively formed on upper and lower surfaces of a substrate;
FIGS. 3 through 6 are graphs showing simulation results of the variation of photoelectric conversion efficiency, fill-factor, short circuit current density, and surface resistance according to the thickness of a front electrode, respectively;
FIG. 7 is a graph showing a simulation result of a photoelectric conversion efficiency according to the width of a photoelectric cell;
FIGS. 8A through 8G are cross-sectional views showing a method of manufacturing a photoelectric module according to an embodiment of the present invention; and
FIG. 9 is a schematic cross-sectional view showing a method of forming optical absorption layers of the first and second photoelectric conversion units according to an embodiment of the present invention.

### DETAILED DESCRIPTION

Photoelectric modules and methods of manufacturing the photoelectric modules, according to embodiments of the present invention, will be described with reference to the accompanying drawings. Further, the use of "may" when describing embodiments of the present invention refers to "one or more embodiments of the present invention." Expressions such as "at least one of," when preceding a list of elements, modify the entire list of elements and do not modify the individual elements of the list. It will be understood that when an element or layer is referred to as being "on," or "connected to" another element or layer, it can be directly on or connected to the other element or layer or intervening elements or layers may be present. When an element is referred to as being "directly on" or "directly connected to" another element or layer, there may be no intervening elements or layers present. As used herein, the term "and/or" includes any and all combinations of one or more of the associated listed items. Spatially relative terms, such as "below," "beneath," "lower," "above," "upper," and the like, may be used herein for ease of description to describe one element or feature's relationship to another element(s) or feature(s) as illustrated in the drawings. It will be understood that the spatially relative terms are intended to encompass different orientations of the device in use or operation in addition to the orientation depicted in the drawings.

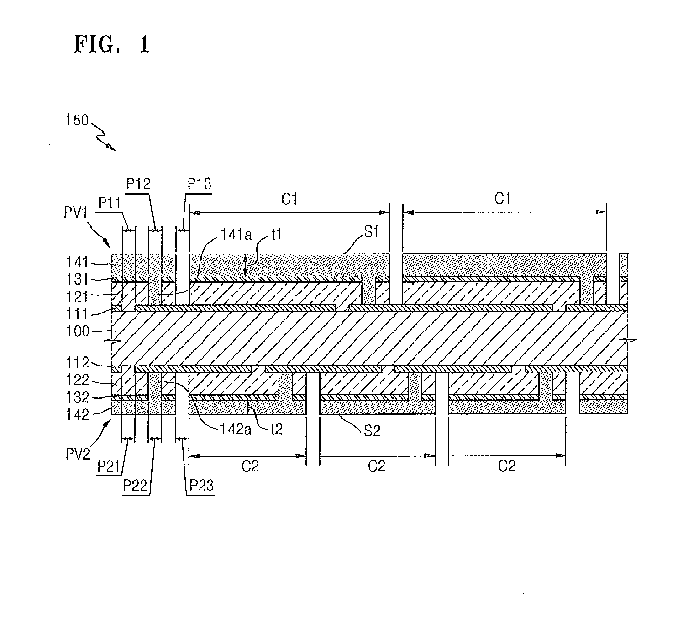

FIG. 1 is a cross-sectional view of a photoelectric module 150 according to an embodiment of the present invention.

Referring to FIG. 1, the photoelectric module 150 includes a plurality of photoelectric cells C1 and C2, and may include at least two photoelectric cells C1 and at least two photoelectric cells C2.

More specifically, the photoelectric module 150 includes a first photoelectric conversion unit PV1 formed on an upper surface of a substrate 100 and a second photoelectric conversion unit PV2 formed on a lower surface of the substrate 100. The first photoelectric conversion unit PV1 includes the photoelectric cells C1 of a first group formed on the upper surface of the substrate 100. The second photoelectric conversion unit PV2 includes the photoelectric cells C2 of a second group formed on the lower surface of the substrate 100. The photoelectric cells C1 and C2 of the first and second groups are respectively formed on the upper and lower surfaces of the substrate 100 that are opposite to each other, and may include at least two photoelectric cells C1 and at least two photoelectric cells C2, respectively.

The first photoelectric conversion unit PV1 generates electrical energy from light incident through a first light-receiving surface S1 on the substrate 100, and the second photoelectric conversion unit PV2 generates electrical energy from light incident through a second light-receiving surface S2 under the substrate 100. The photoelectric module 150 according to the current embodiment generates electrical energy by utilizing lights entering through both the first and second light-receiving surfaces S1 and S2, and thus, may perform photoelectric conversion with high efficiency.

The first photoelectric conversion unit PV1 includes a rear electrode 111, an optical absorption layer 121, and a front electrode 141. For example, the rear electrode 111 and the front electrode 141 may be respectively formed and named according to their relative positions with respect to the first light-receiving surface S1. That is, the front electrode 141 of the first photoelectric conversion unit PV1 is located on the outer side of the first photoelectric conversion unit PV1 and is adapted to receive light, while the rear electrode 111 of the first photoelectric conversion unit PV1 is located on the inner side of the first photoelectric conversion unit PV1 and closer to the substrate than the front electrode 141. The rear electrode 111, the optical absorption layer 121, and the front electrode 141 are separated by a first separation pattern P11, a second separation pattern P12, and a third separation pattern P13, respectively.

The front electrode 141 of the first photoelectric conversion unit PV1 is located on the outer side of the first photoelectric conversion unit PV1 and is adapted to receive light, while the rear electrode 111 of the first photoelectric conversion unit PV1 is located on the inner side of the first photoelectric conversion unit PV1 and closer to the substrate than the front electrode 141.

The second photoelectric conversion unit PV2 includes a rear electrode 112, an optical absorption layer 122, and a front electrode 142. For example, the rear electrode 112 and the front electrode 142 may be respectively formed and named according to their relative positions with respect to the second light-receiving surface S2. That is, the front electrode 142 of the second photoelectric conversion unit PV2 is located on the outer side of the second photoelectric conversion unit PV2 and is adapted to receive light, while the rear electrode 112 of the second photoelectric conversion unit PV2 is located on the inner side of the second photoelectric conversion unit PV2 and closer to the substrate than the front electrode 142. The rear electrode 112, the optical absorption layer 122, and the front electrode 142 are separated by a first separation pattern P21, a second separation pattern P22, and a third separation pattern P23, respectively.

The front electrode 142 of the second photoelectric conversion unit PV2 is located on the outer side of the second photoelectric conversion unit PV2 and is adapted to receive light, while the rear electrode 112 of the second photoelectric conversion unit PV2 is located on the inner side of the second photoelectric conversion unit PV2 and closer to the substrate than the front electrode 142.

A pair of the rear electrodes 111 and 112, a pair of the optical absorption layers 121 and 122, and a pair of the front electrodes 141 and 142 that constitute the first and second photoelectric conversion units PV1 and PV2 may each (e.g., each pair) be consecutively formed through a continuous process or may be formed concurrently (e.g., simultaneously) through a single process. For example, the pair of the rear electrodes 111 and 112 that constitute the first and second photoelectric conversion units PV1 and PV2 may be consecutively formed through a flip step process by which the substrate 100 to be processed is overturned in the same chamber.

The pair of the front electrodes 141 and 142 that constitute the first and second photoelectric conversion units PV1 and PV2 may be consecutively formed through a flip step process by which the substrate 100 to be processed is overturned in the same chamber. As described below, for the formation of the front electrodes 141 and 142, the flip step process may be omitted by applying a reactive plasma deposition (RPD) process.

As described below, a selenization for forming the optical absorption layers 121 and 122 may be performed on both upper and lower surfaces of the substrate 100, and the pair of the optical absorption layers 121 and 122 that constitute the first and second photoelectric conversion units PV1 and PV2 may be concurrently (e.g., simultaneously) formed by performing the same process in the same chamber. Also, a pair of buffer layers 131 and 132 that are formed on an upper surface of the optical absorption layer 122 and a lower surface of the optical absorption layer 121 may be concurrently (e.g., simultaneously) formed through the same process, and an annealing process may also be concurrently (e.g., simultaneously) performed on both upper and lower surfaces of the substrate 100. In this manner, some of the processes for forming the first and second photoelectric conversion units PV1 and PV2 may be concurrently (e.g., simultaneously) performed as a single process without the need of repeatedly performing each of the processes. The processes will be described in more detail below.

The substrate 100 may be a glass substrate. More specifically, the substrate 100 may be formed of soda-lime glass. However, the substrate 100 according to the current embodiment is not limited thereto, and the substrate 100 may be a ceramic substrate, a metal substrate that includes stainless steel or titanium, or a polymer substrate that includes polyimide.

The rear electrodes 111 and 112 may be formed of an electrical conductor. For example, the rear electrodes 111 and 112 may be formed as a molybdenum thin film, and may be formed by using a sputtering process in which molybdenum is used as a target. As a material of the rear electrodes 111 and 112, molybdenum may form an ohmic contact and may have high temperature stability under a selenium atmosphere. The rear electrodes 111 and 112 may have a low specific resistance, and may have a high adherence with respect to the substrate 100 so the rear electrodes 111 and 112 are not exfoliated (or delaminated) from the substrate 100 due to a thermal expansion coefficient difference therebetween.

According to another embodiment of the current invention, the rear electrodes 111 and 112 may be formed of a metal, such as titanium, tungsten, or a metal oxide, such as indium tin oxide (ITO), tin oxide (SnO₂), or zinc oxide (ZnO), besides molybdenum.

According to another embodiment of the current invention, the rear electrodes 111 and 112 may be formed as a multilayer structure that includes at least two layers. For example, the rear electrodes 111 and 112 may include layers that include different materials.

The rear electrodes 111 and 112 of the neighboring photoelectric cells C1 and C2 are separated from each other by the first separation patterns P11 and P21 and may be electrically insulated from each other. That is, the rear electrodes 111 of the neighboring photoelectric cells C1 of the first group are electrically insulated from each other by the first separation pattern P11, and similarly, the rear electrodes 112 of the photoelectric cells C2 of the second group may be electrically insulated from each other by the first separation pattern P21.

For example, the first separation patterns P11 and P21 may be formed by a laser scribing method or a mechanical scribing method, and thus layers of the rear electrodes 111 and 112 may be separated into rear electrodes 111 and 112 of different photoelectric cells C1 and C2 by the first separation patterns P11 and P21.

The optical absorption layers 121 and 122 may be formed on an upper surface of the rear electrode 111 and a lower surface of the rear electrode 112, respectively. The optical absorption layers 121 and 122 may generate a photo electromotive force according to a photoelectric effect by using light incident through the first and second light-receiving surfaces S1 and S2. The optical absorption layers 121 and 122 may include a chalcopyrite semiconductor. More specifically, the optical absorption layers 121 and 122 may include a Cu(In,Ga)Se₂ (CIGS) group compound.

The optical absorption layers 121 and 122 may be formed by selenization. For example, after forming a precursor including a CuGa/In layer that includes a Cu-Ga alloy layer and an Indium layer through sputtering, the optical absorption layers 121 and 122 are formed through selenization or sulfurization of the precursor.

In another embodiment of the present invention, the optical absorption layers 121 and 122 include a CuInSe₂ (CIS) group compound, and also, in another embodiment, the optical absorption layers 121 and 122 include a CuGaSe₂ (CGS) group alloy.

The optical absorption layers 121 and 122 of the neighboring photoelectric cells C1 and C2 are separated from each other by the second separation patterns P12 and P22 and may be electrically insulated from each other. That is, the optical absorption layers 121 of the neighboring photoelectric cells C1 are electrically insulated from each other by the second separation pattern P12, and similarly, the optical absorption layers 122 of the photoelectric cells C2 are insulated from each other by the second separation pattern P22.

For example, the second separation patterns P12 and P22 may be formed by a laser scribing method or a mechanical scribing method, and thus, the optical absorption layers 121 and 122 respectively formed on the substrate 100 may be separated into optical absorption layers 121 and 122 of different photoelectric cells C1 and C2 by the second separation patterns P12 and P22.

A pair of buffer layers 131 and 132 are formed on an upper surface of the optical absorption layer 121 and a lower surface of the optical absorption layer 122, respectively. The buffer layers 131 and 132 may form a favorable junction between the optical absorption layers 121 and 122 and the front electrodes 141 and 142. For example, when a p-n junction is formed between the p-type optical absorption layers 121 and 122 and the n-type front and rear electrodes 141 and 142, due to a large energy band gap between the two materials, the buffer layers 131 and 132 having an intermediate band gap between the two materials may be formed therebetween. For example, the buffer layers 131 and 132 may be a CdS thin film or a ZnS thin film, and also, the buffer layers 131 and 132 may be an InS thin film in addition to the CdS thin film and the ZnS thin film. For example, the buffer layers 131 and 132 may be deposited by a chemical bath deposition (CBD) method.

In another embodiment of the current invention, the buffer layers 131 and 132 may be formed as a multilayer structure having at least two layers. For example, the buffer layers 131 and 132 may include layers that include different materials, and more specifically, may be formed as a multilayer structure in which the ZnS thin film is formed on the CdS thin film.

For example, the buffer layers 131 and 132 may be separated from each other together with the optical absorption layers 121 and 122 by the second separation patterns P12 and P22, and through the second separation patterns P12 and P22, the buffer layers 131 and 132 of the photoelectric cells C1 and C2 may be electrically insulated from each other.

The front electrodes 141 and 142 are formed on the buffer layer 131 and under the buffer layer 132, respectively. Since the front electrodes 141 and 142 or the buffer layers 131 and 132 may form a p-n junction with the optical absorption layers 121 and 122, and the front electrodes 141 and 142 are located on the first and second light-receiving surfaces S1 and S2 to perform as electrodes, the front electrodes 141 and 142 may be formed of a transparent conductive material having a high transmissivity and a high electrical conductivity. For example, the front electrodes 141 and 142 may include a metal oxide, such as ITO, SnO₂, or ZnO. Also, the metal oxide may include a material in which at least one impurity is mixed therein. For example, the front electrodes 141 and 142 may be formed of ZnO doped with boron, aluminum, or gallium to increase the electrical conductivity thereof. For example, upper surface of the front electrode 141 and lower surface of the front electrode 142 may form the first and second light-receiving surfaces S1 and S2 of a dual-side light-receiving photoelectric module.

The front electrodes 141 and 142 of the neighboring photoelectric cells C1 and C2 are separated from each other by third separation patterns P13 and P23, and may be electrically insulated from each other. That is, the front electrodes 141 of the neighboring photoelectric cells C1 of the first group are electrically insulated by the third separation pattern P13, and similarly, the front electrodes 142 of the neighboring photoelectric cells C2 of the second group are electrically insulated by the third separation pattern P23.

For example, the third separation patterns P13 and P23 may be formed by a laser scribing method or a mechanical scribing method, and layers of the front electrodes 141 and 142 respectively formed on the substrate 100 may be separated into front electrodes 141 and 142 of different photoelectric cells C1 and C2 by the third separation pattern P13 and P23.

The neighboring photoelectric cells C1 and C2 may be modulated by being connected in series or parallel to each other. For example, the neighboring photoelectric cells C1 and C2 may be connected in series or parallel to each other in accordance with a required output voltage or output current. As shown in FIG. 1, the rear electrode 111 and the front electrode 141 of the photoelectric cells C1 of the neighboring first groups may form a series connection by being connected in series to each other. Similarly, the rear electrode 112 and the front electrode 142 of the photoelectric cells C2 of the neighboring second groups may form a series connection by being connected in series to each other.

For example, the neighboring photoelectric cells C1 and C2 may be electrically connected to each other through connection units 141 a and 142a, and the rear electrodes 111 and 112 of one of the photoelectric cells C1 and C2 and the front electrodes 141 and 142 of the neighboring photoelectric cells C1 and C2 may be electrically connected to each other by the connection units 141 a and 142a of the front electrodes 141 and 142 that are respectively formed to pass through the optical absorption layers 121 and 122 through the second separation patterns P12 and P22. For example, the connection units 141 a and 142a may be formed as parts of the front electrodes 141 and 142 that pass through the optical absorption layers 121 and 122 through the second separation patterns P12 and P22, and portions of the front electrodes 141 and 142 covering the optical absorption layers 121 and 122 through which the second separation patterns P12 and P22 are formed may perform as the connection units 141 a and 142a, but the present invention is not limited thereto.

As shown in FIG. 1, the photoelectric module 150 according to the current embodiment is formed as a dual-side light-receiving photoelectric module having the first and second light-receiving surfaces S1 and S2 formed on the upper and lower surfaces of the substrate 100. For example, the first photoelectric conversion unit PV1 formed on the upper surface of substrate 100 may directly receive incident light, and the second photoelectric conversion unit PV2 formed on the lower surface of the substrate 100 may receive reflected light that is reflected by a reflection mirror. That is, the front electrode 141 of the first photoelectric conversion unit PV1 directly receives the incident light, and the front electrode 144 of the second photoelectric conversion unit PV2 receives reflected light that is reflected by a reflection mirror. Accordingly, under the same solar condition, the intensity of light that enters the first photoelectric conversion unit PV1 may be relatively greater than that of light that enters the second photoelectric conversion unit PV2.

The first photoelectric conversion unit PV1 formed on the substrate 100 and the second photoelectric conversion unit PV2 formed under the substrate 100 may generally have a structure similar to each other, but may have different structures according to the intensity difference of incident light. Hereinafter, the structure is described in more detail.

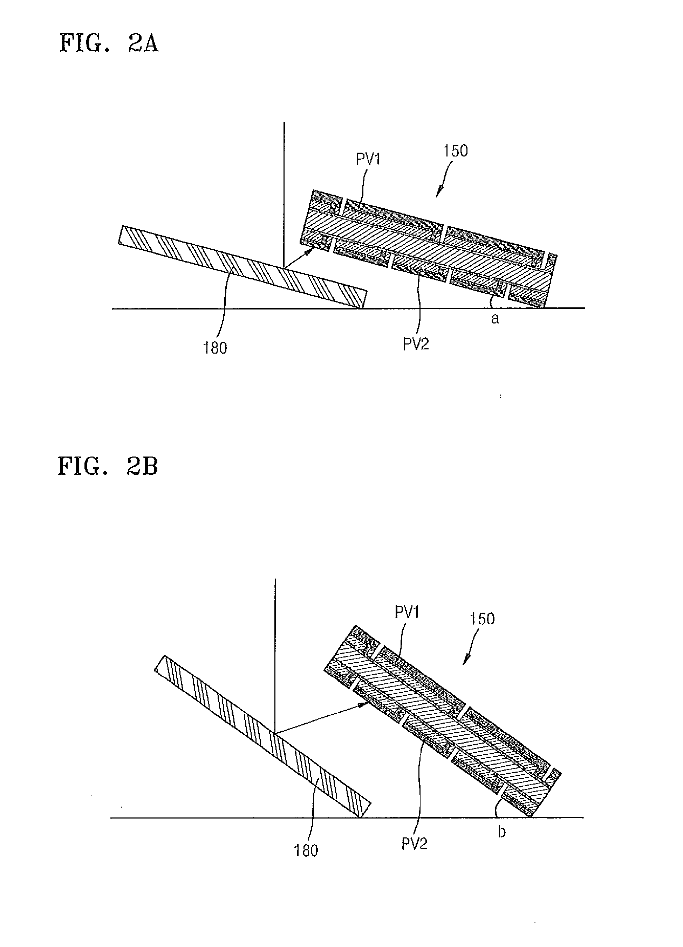

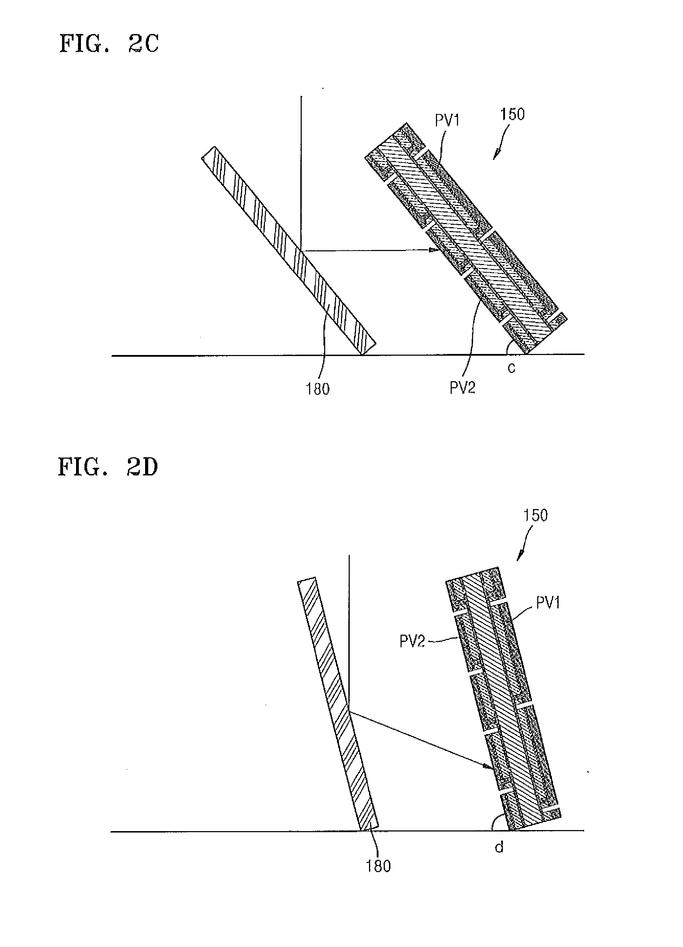

FIGS. 2A through 2D are schematic cross-sectional views of a model for simulating an intensity difference of incident light between the first and second photoelectric conversion units PV1 and PV2 formed respectively on the upper and lower surfaces of the substrate 100. In FIGS. 2A through 2D, the photoelectric module 150 is fixed at various installation angles a, b, c, and d with respect to a constant altitude of the sun, and solar light enters into the photoelectric module 150 at various incident angles. Further, in the case when the installation angles a, b, c, and d of the photoelectric module 150 are fixed while the altitude of the sun is changed, the incident angles of the solar light may be substantially the same as the cases shown in FIGS. 2A through 2D.

The first photoelectric conversion unit PV1 receives direct incident light from a light source, and the second photoelectric conversion unit PV2 receives incident light reflected by a reflection mirror 180 that is installed parallel to the photoelectric module 150.

Table 1 summarizes the intensity of incident light of the first and second photoelectric conversion units PV1 and PV2, and the ratio of the intensity of incident light of the second photoelectric conversion unit PV2 to the intensity of incident light of the first photoelectric conversion unit PV1 in the cases shown in FIGS. 2A through 2D.

**Table 1**

| Installation angle | a | b | c | d |
|---|---|---|---|---|
| First photoelectric conversion unit | 0.981 | 0.816 | 0.466 | 0.212 |
| Second photoelectric conversion unit | 0.016 | 0.042 | 0.046 | 0.045 |
| Ratio (%) | 1.59 | 5.11 | 9.76 | 21.09 |

As shown in Table 1, the intensity of incident light of the second photoelectric conversion unit PV2 is at a level in a range from about 1.59 % to about 21.09 % of that of the first photoelectric conversion unit PV1.

Referring to FIG. 1, in order to compensate for the relatively low intensity of incident light, the front electrode 142 of the second photoelectric conversion unit PV2 may be formed to have a relatively small thickness. That is, when the front electrode 142 of the second photoelectric conversion unit PV2 has a small thickness, an optical transmissivity of the photoelectric module 150 may be increased, and thus, an appropriate intensity of incident light may be ensured. For example, the lower surface of the front electrode 142 of the second photoelectric conversion unit PV2 may form the second light-receiving surface S2, and optical loss may be reduced by forming the front electrode 142 with a small thickness, and thus, the effective intensity of incident light that is transmitted to the second photoelectric conversion unit PV2 may be ensured to be at an appropriate level.

For example, a thickness t2 of the front electrode 142 of the second photoelectric conversion unit PV2 may be formed smaller than a thickness t1 of the front electrode 141 of the first photoelectric conversion unit PV1 (t2<t1). However, since the front electrode 142 of the second photoelectric conversion unit PV2 forms a path (circuit) of electrical current generated by light, if the thickness t2 of the front electrode 142 is excessively small, the photoelectric conversion efficiency of the photoelectric module 150 may be reduced.

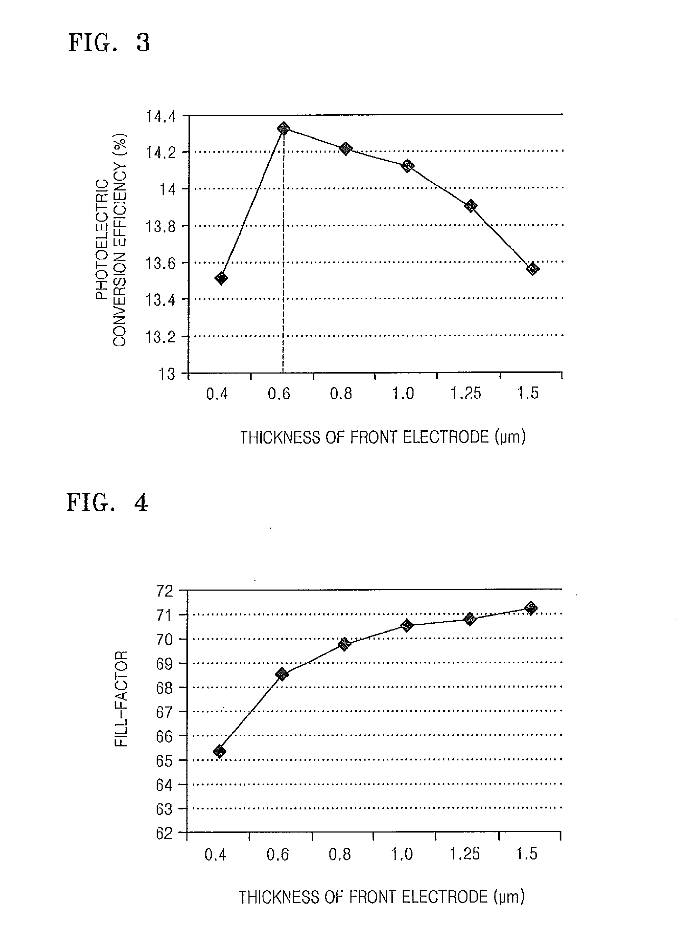

FIGS. 3 through 6 are graphs showing simulation results of the variation of photoelectric conversion efficiency, fill-factor, short-circuit current density, and surface resistance according to the thickness t2 of the front electrode 142, respectively.

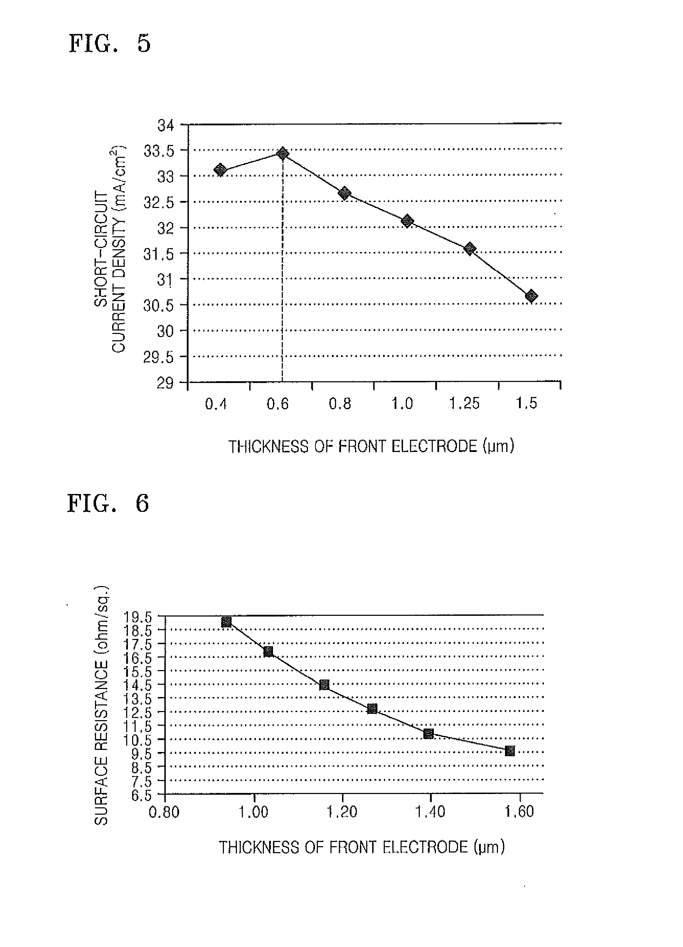

Referring to FIG. 3, it is confirmed that the photoelectric conversion efficiency of the photoelectric module 150 is rapidly reduced when the thickness t2 of the front electrode 142 is smaller than 0.6 µm. That is, as the thickness t2 of the front electrode 142 is reduced, the optical transmissivity of the photoelectric module 150 is increased, and accordingly, the photoelectric conversion efficiency is increased. However, when the thickness t2 of the front electrode 142 is smaller than 0.6 µm, the electrical resistance of the front electrode 142 is increased, and thus, the photoelectric conversion efficiency is rapidly reduced. Also, as shown in FIG. 5, short-circuit current density is increased as the thickness t2 of the front electrode 142 is reduced. However, it is confirmed that when the thickness t2 of the front electrode 142 is smaller than 0.6 µm, the electrical resistance of the front electrode 142 is increased, and thus, the photoelectric conversion efficiency is reduced. Also, as shown in FIG. 6, as the thickness t2 of the front electrode 142 is reduced, the surface resistance of the front electrode 142 is increased. Thus, the front electrode 142 may be formed to have a thickness t2 that is greater than 0.6 µm. Also, as shown in FIG. 4, the fill-factor is reduced as the thickness t2 of the front electrode 142 decreases. Accordingly, it is necessary to ensure that the thickness t2 of the front electrode 142 is at an appropriate level. Accordingly, the thickness t2 of the front electrode 142 of the second photoelectric conversion unit PV2 may be at least 0.6 µm, and may be formed smaller than the thickness t1 of the front electrode 141 of the first photoelectric conversion unit PV1 (0.6µm ≤ t2 < t1).

As the thickness t2 of the front electrode 142 of the second photoelectric conversion unit PV2 is formed relatively small, an electrical resistance of the front electrode 142 is increased. In order to compensate for the increased electrical resistance, a cell width (corresponds to photoelectric cells C2 of FIG. 1) of the second photoelectric conversion unit PV2 may be limited (or reduced). For example, when a plural number of photoelectric cells C2 having a relatively narrow width are formed on the same area of the substrate 100, a width of the photoelectric cells C2 that are allocated to a single front electrode 142 is limited (or reduced) as much as possible, and thus, the increased electrical resistance may be compensated for and an appropriate level of photoelectric conversion efficiency may be obtained. For example, the width of the photoelectric cells C2 of the second photoelectric conversion unit PV2 may be formed narrower than the width (corresponds to the photoelectric cells C1) of the photoelectric cells C1 of the first photoelectric conversion unit PV1 (C2 <C1).

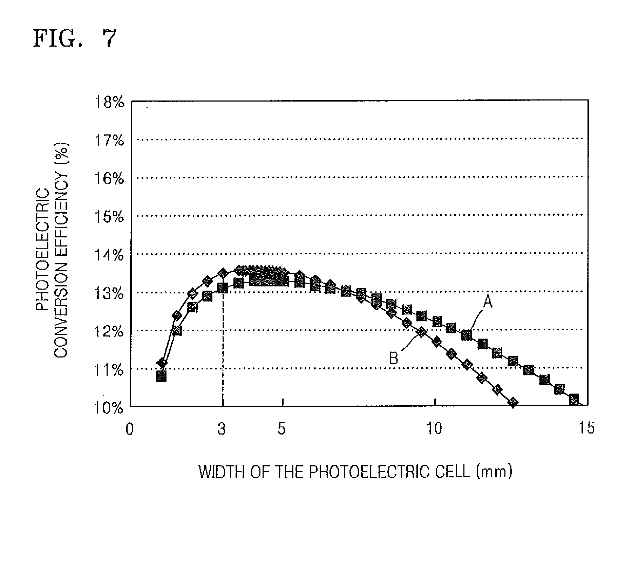

FIG. 7 is a graph showing a simulation result of the photoelectric conversion efficiency according to the width of the photoelectric cells C2. Profiles A and B in FIG. 7 are the result of the photoelectric conversion efficiency obtained by changing the width of the photoelectric cells C2 with respect to different thicknesses t2 of the front electrodes 142.

Referring to FIG. 7, it is confirmed that the photoelectric conversion efficiency is rapidly reduced when the photoelectric cells C2 have a width smaller than 3 mm. As the width of the photoelectric cells C2 is reduced, an electrical conductivity characteristic is increased as a result of the reduction of the width of the photoelectric cells C2, and thus, the photoelectric conversion efficiency may be increased. However, it is understood that, when the photoelectric cells C2 have a width smaller than 3 mm, a ratio of dead-area of the photoelectric cells C2 is relatively increased, and thus, the photoelectric conversion efficiency may be reduced.

From the above descriptions, the width of the photoelectric cells C2 of the second photoelectric conversion unit PV2 may be formed greater than 3 mm and may be formed narrower than that of the photoelectric cells C1 of the first photoelectric conversion unit PV1 (3mm ≤ C2 < C1). For example, the width of the photoelectric cells C1 may correspond to the distance between the third separation patterns P13 of two neighboring first photoelectric cells, and the width of the photoelectric cells C2 may correspond to the distance between the third separation patterns P23 of two neighboring second photoelectric cells, because the third separation patterns P13 and P23 separate the front electrodes 141 and 142.

In the first and second photoelectric conversion units PV1 and PV2, the distance between the first separation patterns P11 of two neighboring first photoelectric cells and the distance between the first separation patterns P21 of two neighboring second photoelectric cells (and the distance between the second separation patterns P12 and between the second separation patterns P22) may be increased or decreased according to the widths of the photoelectric cells C1 and C2. For example, when the widths of the photoelectric cells C1 and C2 correspond to the distances between the third separation patterns P13 and P23, in view of the safety margin based on the location of the third separation patterns P13 and P23, the locations of the first and second separation patterns P11, P12, P21 and P22 may be determined not to overlap with each other. Accordingly, when the width of the second photoelectric conversion unit PV2 is formed narrower than that of the first photoelectric conversion unit PV1 with respect to the distance between the third separation patterns P13 and P23, the first and second separation patterns P12, and P22 of the second photoelectric conversion unit PV2 may be formed smaller than that between the corresponding first and second separation patterns P11 and P21 of the first photoelectric conversion unit PV1.

In the current embodiment, a dual-side light-receiving type photoelectric module having the light-receiving surfaces S1 and S2 on the upper and lower surfaces thereof is provided, but the first and second photoelectric conversion units PV1 and PV2 formed on and under the substrate 100 in the dual-side light-receiving type photoelectric module have different structures from each other. That is, the thicknesses t1 and t2 of the front electrodes 141 and 142 and the widths of the photoelectric cells C1 and C2 of the first and second photoelectric conversion units PV1 and PV2 are differently designed so that the second photoelectric conversion unit PV2 that has a relatively low intensity of incident light is able to obtain an appropriate photoelectric conversion efficiency.

According to another embodiment of the present invention, the optical absorption layers 121 and 122 of the first and second photoelectric conversion units PV1 and PV2 may have different compositions. For example, when the optical absorption layers 121 and 122 include a CIGS group compound, the optical absorption layers 121 and 122 of the first and second photoelectric conversion units PV1 and PV2 may have a different composition ratio of Cu-In-Se. In consideration of the difference of intensity of incident light of the first and second photoelectric conversion units PV1 and PV2 described above, the optical absorption layers 121 and 122 may be differently designed.

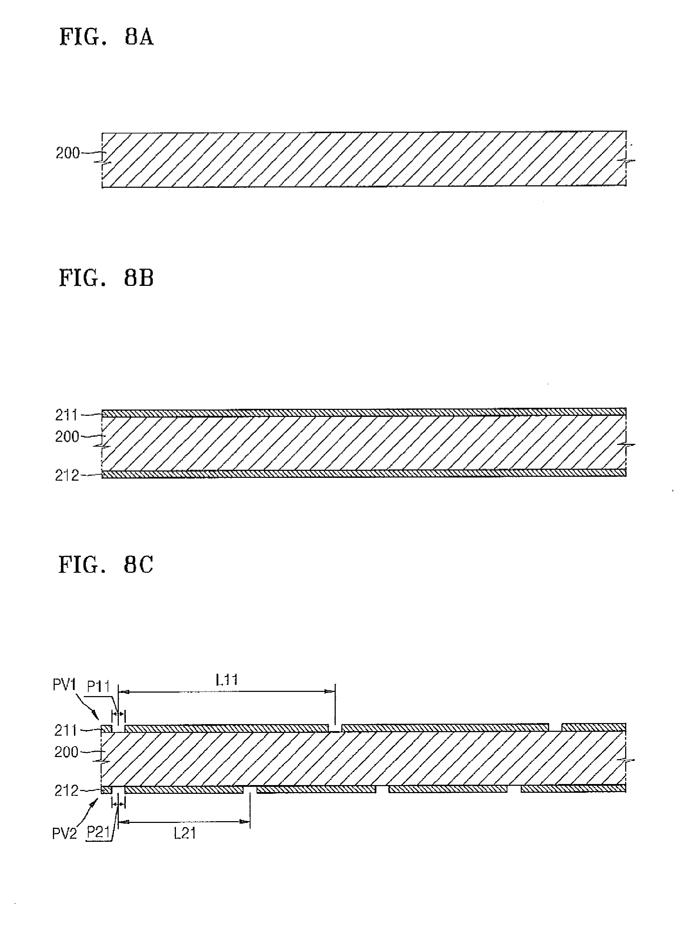

Hereinafter, a method of manufacturing a photoelectric module according to the current embodiment will be described. FIGS. 8A through 8G are cross-sectional views showing a method of manufacturing the photoelectric module.

Referring to FIG. 8A, a substrate 200 is prepared. The substrate 200 may be a glass substrate. A washing process may be applied to the substrate 200. The washing processes with respect to both upper and lower surfaces of the substrate 200, on which the first and second photoelectric conversion units PV1 and PV2 are to be formed, may be performed at the same time. For example, the washing process may use deionized (DI) water or tetramethylammonium hydroxide (TMAH).

Next, referring to FIG. 8B, rear electrodes 211 and 212 are formed on the upper and lower surfaces of the substrate 200, respectively. For example, the rear electrodes 211 and 212 may be formed by a sputtering process using molybdenum as a target. After performing a sputtering on an upper surface of the substrate 200, another sputtering may be consecutively performed on a lower surface of the substrate 200 by using a flip step process by which the substrate 200 is overturned. Accordingly, the rear electrodes 211 and 212 respectively formed on the upper and lower surfaces of the substrate 200 may be formed in the same chamber. After completing a sputtering on the upper surface of the substrate 200, the sputtering on the lower surface of the substrate 200 may be consecutively performed by using a flip step process by which the upper and lower surfaces of the substrate 200 are overturned.

Next, referring to FIG. 8C, the rear electrodes 211 and 212 are separated by separating layers of the rear electrodes 211 and 212 formed on the upper and lower surfaces the substrate 200. For example, a first patterning for separating the layer of the rear electrode 211 formed on one side of the substrate 200 is performed, and afterwards, after performing a flip step process to overturn the upper and lower surfaces of the substrate 200 to be processed, a second patterning for separating the layer of the rear electrode 212 on the other side of the substrate 200 may be performed.

For example, in the first and second patternings, the first separation patterns P11 and P21 may be formed by a laser scribing method or a mechanical scribing method. The layers of the rear electrodes 211 and 212 respectively formed on the upper and lower surfaces of the substrate 200 may be separated into a plural number of rear electrodes 211 and 212 of different photoelectric cells by the first separation patterns P11 and P21.

The first separation patterns P11 and P21 may be respectively formed on the upper and lower surfaces of the substrate 200 with different distances. More specifically, the distance L21 of the first separation pattern P21 (the distance between two first separation patterns P21 of neighboring second photoelectric cells) formed on the lower surface of the substrate 200 may be formed smaller than the distance L11 of the first separation pattern P11 (the distance between two first separation patterns P11 of neighboring first photoelectric cells) formed on the upper surface of the substrate 200 (L21 < L11). The distances L11 and L21 of the first separation patterns P11 and P21 are designed in consideration of the intensities of incident light to the first and second photoelectric conversion units PV1 and PV2 respectively formed on the upper and lower surfaces of the substrate 200.

The first photoelectric conversion unit PV1 formed on the upper surface of the substrate 200 receives direct light from a light source, whereas the second photoelectric conversion unit PV2 formed on the lower surface of the substrate 200 receives light reflected by a reflection member. Therefore, instead of increasing the optical transmissivity by forming the front electrode 142 of the second photoelectric conversion unit PV2 to be thin, the lower electrical conductivity of the front electrode 142 is compensated for by forming a width of a photoelectric cell to be relatively small.

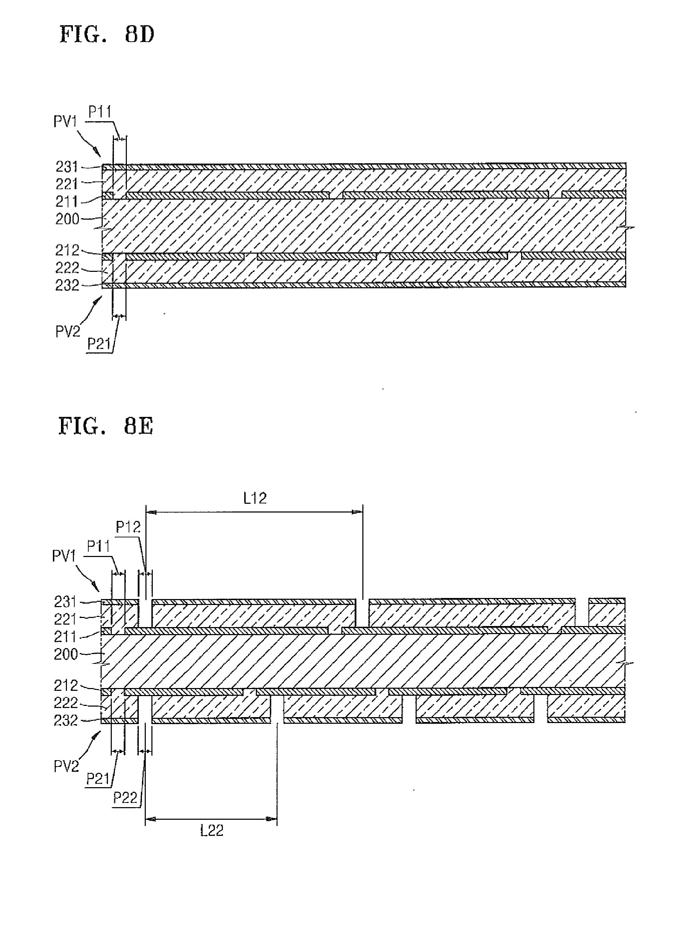

Next, referring to FIG. 8D, optical absorption layers 221 and 222 are formed on the rear electrodes 211 and 212 formed on the upper and lower surfaces of the substrate 200, respectively. For example, the optical absorption layers 221 and 222 may include a chalcopyrite semiconductor, and more specifically, may include a Cu(In,Ga)Se₂ (CIGS) group compound. The optical absorption layers 221 and 222 may be formed by selenization described below.

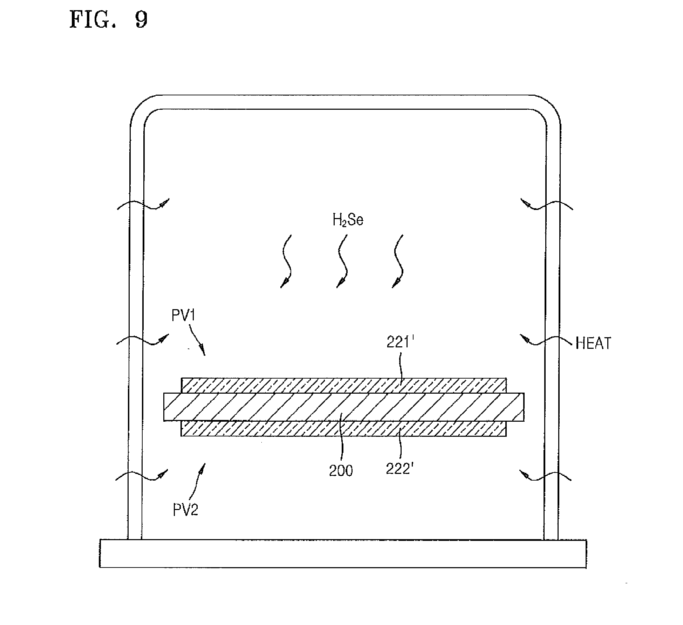

FIG. 9 is a schematic cross-sectional view showing a method of forming the optical absorption layers 221 and 222 of the first and second photoelectric conversion units PV1 and PV2. Referring to FIG. 9, a precursor 221' is formed on the substrate 200 by sputtering. For example, the precursor 221' may be formed as a CuGa/In layer that includes a Cu-Ga alloy layer and an In layer. After overturning a surface of the substrate 200 to be processed through a flip step process by which the upper and lower surfaces of the substrate 200 are overturned, a precursor 222' may be formed on the lower surface of the substrate 200. The precursors 221' and 222' respectively formed on the upper and lower surfaces of the substrate 200 may be formed in the same chamber, and the precursors 221' and 222' may be consecutively formed on the upper and lower surfaces of the substrate 200 through a flip step process by which a surface of the substrate 200 to be processed is overturned.

Also, the optical absorption layers 221 and 222 are formed by selenizing the precursors 221' and 222' respectively formed on the upper and lower surfaces of the substrate 200. The selenization may be concurrently (e.g., simultaneously) performed on the precursors 221' and 222' respectively formed on the upper and lower surfaces of the substrate 200. After placing the substrate 200, on which the precursors 221' and 222' are formed, in a chamber, the substrate 200 is heated at a high temperature in a range from about 400 °C to about 600 °C under an H₂Se atmosphere, and then, an alloying of the precursors 221' and 222' respectively formed on the upper and lower surfaces of the substrate 200 occurs to form the optical absorption layers 221 and 222. The selenization is not separately performed but concurrently (e.g., simultaneously) performed on the upper and lower surfaces of the substrate 200. Accordingly, the process for manufacturing a dual-side light-receiving photoelectric module is simplified.

According to another embodiment of the current invention, besides the selenization, the optical absorption layers 221 and 222 may be formed by sulfurization. In this case, the optical absorption layers 221 and 222 may be formed by concurrently (e.g., simultaneously) sulfurizing the precursors 221' and 222' respectively formed on the upper and lower surfaces of the substrate 200 by heating at a high temperature under an H₂S atmosphere after placing the substrate 200, on which the precursors 221' and 222' are formed, in a chamber.

Referring to FIG. 8D, buffer layers 231 and 232 may be formed on the optical absorption layers 221 and 222 formed on the upper and lower surfaces of the substrate 200, respectively. The formation of the buffer layers 231 and 232 may not be separately performed but rather concurrently (e.g., simultaneously) performed on the upper and lower surfaces of the substrate 200. The buffer layers 231 and 232 may be formed by a CBD method. For example, the buffer layers 231 and 232 may be formed such that the substrate 200, on which the optical absorption layers 221 and 222 are formed, is dipped in a bath containing a solution that includes CdS while the solution is being stirred.

Next, an annealing process may be performed. The annealing process may be performed to dry and stabilize the substrate 200, on which the optical absorption layers 221 and 222 and the buffer layers 231 and 232 are formed, after performing a wet process, such as a CBD process. The annealing process may not be separately performed but rather concurrently (e.g., simultaneously) performed on the upper and lower surfaces of the substrate 200. Accordingly, the process of manufacturing a dual-side light-receiving photoelectric module may be simplified.

Next, as depicted in FIG. 8E, the optical absorption layers 221 and 222 and the buffer layers 231 and 232 that are respectively formed on the upper and lower surfaces of the substrate 200 are separated into optical absorption layers 221 and 222 and buffer layers 231 and 232 of different photoelectric cells. For example, a first patterning for separating the optical absorption layer 221 and the buffer layer 231 that are formed on the substrate 200 is performed, and after performing a flip step process by which the upper and lower surfaces of the substrate 200 to be processed are overturned, a second patterning for separating the optical absorption layer 222 and the buffer layer 232 that are formed on the lower surface of the substrate 200 may be performed.

For example, in the first and second patternings, second separation patterns P12 and P22 may be formed by a laser scribing method or a mechanical scribing method. The optical absorption layers 221 and 222 and the buffer layers 231 and 232 that are respectively formed on the upper and lower surfaces of the substrate 200 may be separated into optical absorption layers 221 and 222 and buffer layers 231 and 232 of different photoelectric cells by the second separation patterns P12 and P22.

The second separation patterns P12 and P22 on and under the substrate 200 may be formed with different distances. More specifically, the distance L22 of the second separation pattern P22 (the distance between two second separation patterns P22 of neighboring second photoelectric cells) formed under the substrate 200 may be smaller than the distance L12 of the second separation pattern P12 (the distance between two second separation patterns P12 of neighboring first photoelectric cells) formed on the substrate 200 (L22<L12). The distances of the second separation patterns P12 and P22 are designed in consideration of the intensities of incident light of the first and second photoelectric conversion units PV1 and PV2 respectively formed on the upper and lower surfaces of the substrate 200.

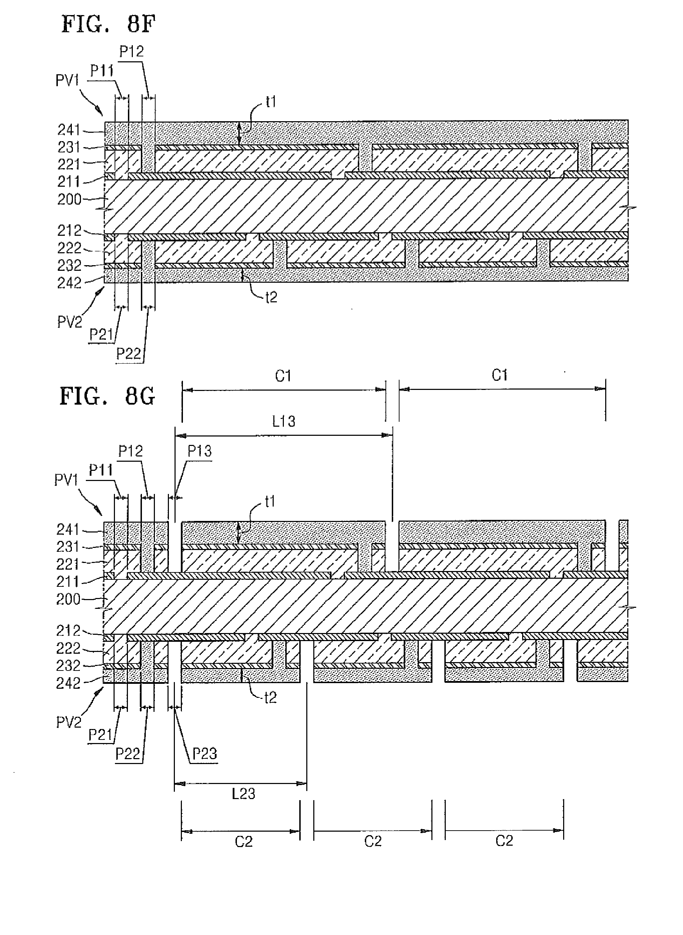

Next, as depicted in FIG. 8F, layers of front electrodes 241 and 242 are formed on the buffer layers 231 and 232 that are formed on the upper and lower surfaces of the substrate 200, respectively. The layers of the front electrodes 241 and 242 may be formed of a metal oxide selected from ITO, SnO₂, and ZnO. Also, the metal oxide may include a material that includes at least one impurity, and in order to increase the electrical conductivity of the front electrodes 241 and 242, the layers of the front electrodes 241 and 242 may be formed of ZnO doped with boron, aluminum, or gallium.

The layers of the front electrodes 241 and 242 formed on and under the substrate 200 may be formed through the same process, and may be formed by sputtering using ZnO as a target. For example, after performing a sputtering for the layer of the front electrode 241 on one side of the substrate 200, a flip step process for overturning the substrate 200 is performed, and afterwards, a sputtering for the layer of the front electrode 242 on the other side of the substrate 200 may be consecutively performed. Accordingly, the front electrodes 241 and 242 formed on and under the substrate 200 may be formed by the same process performed before and after the flip step process.

According to another embodiment of the present invention, the front electrodes 241 and 242 formed on and under the substrate 200 may be formed by different processes. For example, after performing sputtering on the layer on the substrate 200, an RPD process with respect to the layer under the substrate 200 may be consecutively performed. In the sputtering, a source material is deposited on the substrate 200 to be processed by supplying the source material above the substrate 200. However, in the RPD process, a source material is deposited on a lower side of the substrate 200 to be processed by supplying the source material below the substrate 200. Accordingly, the front electrode 241 on the upper side of substrate 200 may be formed by a sputtering process, and the front electrode 242 on the lower side of the substrate 200 may be formed by an RPD process. In this case, the flip step process for overturning the surfaces of substrate 200 may be omitted.

The front electrodes 241 and 242 formed on and under the substrate 200 may be formed to have different thicknesses. That is, the front electrode 242 of the second photoelectric conversion unit PV2 that has a relatively low intensity of incident light may be formed to have a thickness t2 that is smaller than the thickness t1 of the front electrode 241 of the first photoelectric conversion unit PV1 that has a relatively high intensity of incident light (t2<t1). An optical loss of the photoelectric module 150 may be reduced and the effective intensity of incident light transmitted to the second photoelectric conversion unit PV2 may be ensured to be at an appropriate level by forming the front electrode 242 to have a thickness t2 that is relatively small.

Next, as depicted in FIG. 8G, the layers of the front electrodes 241 and 242 formed on and under the substrate 200 are separated into individual front electrodes 241 and 242 of each photoelectric cell C1 and C2. For example, after performing a first patterning for separating the layer of the front electrodes 241 formed on the substrate 200, a flip step process for overturning the upper and lower surfaces of the substrate 200 to be processed is performed, and afterwards, a second patterning for separating the layer of the front electrode 242 formed under the substrate 200 is performed.

In the first and second patternings, third separation patterns P13 and P23 may be formed by a laser scribing method or a mechanical scribing method. The layers of the front electrodes 241 and 242 respectively formed on and under the substrate 200 may be separated into front electrodes 241 and 242 of different photoelectric cells C1 and C2 by the third separation patterns P13 and P23.

The third separation patterns P13 and P23 on and under the substrate 200 may be formed to have different distances. More specifically, the third separation pattern P23 under the substrate 200 may be formed to have a distance L23 (the distance between two third separation patterns P23 of neighboring second photoelectric cells) that is smaller than the distance L13 (the distance between two third separation patterns P13 of neighboring first photoelectric cells) of the third separation pattern P13 on the substrate 200 (L23<L13). The distances L13 and L23 of the first separation patterns P13 and P23 are designed in consideration of the intensities of incident light to the first and second photoelectric conversion units PV1 and PV2 respectively formed on the upper and lower surfaces of the substrate 200. For example, the distances L13 and L23 of the third separation patterns P13 and P23 may correspond to widths of the photoelectric cells C1 and C2. The width of the photoelectric cell C2 of the second photoelectric conversion unit PV2 formed under the substrate 200 may be smaller than the width of the photoelectric cell C1 of the first photoelectric conversion unit PV1 formed on the substrate 200 (C2<C1).

The first photoelectric conversion unit PV1 formed on the upper surface of the substrate 200 receives light directly from a light source, whereas the second photoelectric conversion unit PV2 formed on the lower surface of the substrate 200 receives light reflected by a reflection member. Therefore, instead of increasing the optical transmissivity of the second photoelectric conversion unit PV2 by forming the thickness t2 of the front electrode 242 to be small, a low electrical conductivity of the front electrode 242 is compensated for by forming the width of the photoelectric cell C2 to be relatively small.

According to embodiments of the present invention, a dual-side light-receiving photoelectric module having light-receiving surfaces on both sides of a substrate is provided, but photoelectric conversion units formed on the both sides of the substrate are formed to have different structures. In this way, appropriate photoelectric conversion efficiency is obtained even from a photoelectric conversion unit that receives a relatively low intensity of incident light.

It should be understood that the example embodiments described herein should be considered in a descriptive sense only and not for purposes of limitation. Descriptions of features or aspects within each embodiment should typically be considered as available for other similar features or aspects in other embodiments. While embodiments of the present invention has been particularly shown and described with reference to example embodiments thereof, it will be understood by those of ordinary skill in the art that various changes in form and details may be made therein without departing from the scope of embodiments of the present invention as defined by the following claims, and equivalents thereof.

## Claims

1. A photoelectric module comprising:
a substrate;
a first photoelectric conversion unit on the substrate and having a first light-receiving surface and a front electrode; and
a second photoelectric conversion unit under the substrate and having a second light-receiving surface and a front electrode,
wherein the front electrode of the second photoelectric conversion unit has a thickness smaller than that of the front electrode of the first photoelectric conversion unit.

2. A photoelectric module according to claim 1, wherein the front electrode of the second photoelectric conversion unit has a thickness of at least 0.6 µm.

3. A photoelectric module according to claim 1 or 2, wherein the first photoelectric conversion unit comprises a plurality of photoelectric cells of a first group and the second photoelectric conversion unit comprises a plurality of photoelectric cells of a second group, and a width of each of the plurality of photoelectric cells of the second group is smaller than that of each of the plurality of photoelectric cells of the first group.

4. A photoelectric module comprising:
a substrate;
a first photoelectric conversion unit on the substrate and comprising a plurality of photoelectric cells of a first group; and
a second photoelectric conversion unit under the substrate and comprising a plurality of photoelectric cells of a second group,
wherein the plurality of photoelectric cells of the second photoelectric conversion unit have a width smaller than that of the plurality of photoelectric cells of the first photoelectric conversion unit.

5. A photoelectric module according to claim 4, wherein the plurality of photoelectric cells of the second group each have a width of at least 3 mm.

6. A photoelectric module according to any preceding claim, wherein the front electrodes of the first and second photoelectric conversion units comprise a transparent conductive material.

7. A photoelectric module according to any preceding claim, wherein
the first photoelectric conversion unit comprises a rear electrode and an optical absorption layer, and the front electrode is sequentially stacked from an upper surface of the substrate, and
the second photoelectric conversion unit comprises a rear electrode and an optical absorption layer, and the front electrode is sequentially stacked from a lower surface of the substrate.

8. A photoelectric module according to claim 7, wherein, when the rear electrodes of the first and second photoelectric conversion units are each separated into a plurality of rear electrodes of neighboring photoelectric cells by a respective plurality of first separation patterns, and a distance between the first separation patterns of two neighboring photoelectric cells in the second photoelectric conversion unit is smaller than that between the first separation patterns of two neighboring photoelectric cells in the first photoelectric conversion unit.

9. A photoelectric module according to claim 7 or 8, wherein, when the optical absorption layers of the first and second photoelectric conversion units are each separated into a plurality of optical absorption layers of neighboring photoelectric cells by a respective plurality of second separation patterns, and a distance between the second separation patterns of two neighboring photoelectric cells in the second photoelectric conversion unit is smaller than that between the second separation patterns of two neighboring photoelectric cells in the first photoelectric conversion unit.

10. A photoelectric module according to any preceding claim, wherein, when the front electrodes of the first and second photoelectric conversion units are each separated into a plurality of front electrodes of neighboring photoelectric cells by a respective plurality of third separation patterns, and a distance between the third separation patterns of two neighboring photoelectric cells in the second photoelectric conversion unit is smaller than that between the third separation patterns of two neighboring photoelectric cells in the first photoelectric conversion unit.

11. A method of manufacturing a photoelectric module, the method comprising:
preparing a substrate;
forming layers of rear electrodes on and under the substrate;
forming first separation patterns to separate the layers of rear electrodes into a plurality of rear electrodes;
forming optical absorption layers on the rear electrodes and respectively located on and under the substrate;
forming buffer layers on the optical absorption layers and respectively located on and under the substrate; and
forming front electrodes on the buffer layers and respectively located on and under the substrate,
wherein the front electrode under the substrate has a thickness smaller than that of the front electrode on the substrate.

12. A method according to claim 11, wherein, in the forming of the optical absorption layers, the optical absorption layers respectively located on and under the substrate are concurrently formed.

13. A method according to claim 12, wherein the forming of the optical absorption layers comprises:
forming a precursor on the substrate;
performing a flip step process for overturning upper and lower surfaces of the substrate;
forming a precursor under the substrate; and
performing selenization in which Se is supplied or sulfurization in which sulfur is supplied onto the precursors formed on and under the substrate, wherein in the performing of the selenization or sulfurization, Se or S is concurrently supplied to the precursors formed on and under the substrate.

14. A method according to any of claims 11 to 13, wherein, in the forming of the buffer layers, the buffer layers formed on and under the substrate are concurrently formed.

15. A method according to any of claims 11 to 14, wherein, after forming the buffer layers, an annealing process for drying the resultant product is performed, the annealing process is concurrently performed with respect to the buffer layers formed on and under the substrate.
